Europäisches Patentamt

European Patent Office

Office européen des brevets

(19)

(11)     **EP 1 331 731 B1**

(12)     **FASCICULE DE BREVET EUROPEEN**

(45) Date de publication et mention
de la délivrance du brevet:
**26.10.2005   Bulletin 2005/43**

(51) Int Cl.⁷: **H03F 3/45**

(21) Numéro de dépôt: **03290084.7**

(22) Date de dépôt: **14.01.2003**

(54) **Etage différentiel d'entrée d'équipement électronique, comportant des moyens pour réduire les perturbations causées par une tension ou un courant en mode commun**

Differenzeingangsstufe eines elektronischen Geräts mit Mitteln zur Reduzierung von Strom- und Spannungsstörungen durch Gleichtaktsignale

Differential input stage of an electronic device with reducing means for current and voltage disturbances from common mode signals

(84) Etats contractants désignés:
**AT BE BG CH CY CZ DE DK EE ES FI FR GB GR HU IE IT LI LU MC NL PT SE SI SK TR**

(30) Priorité: **24.01.2002  FR 0200858**

(43) Date de publication de la demande:
**30.07.2003   Bulletin 2003/31**

(73) Titulaire: **ALCATEL**
**75008 Paris (FR)**

(72) Inventeur: **Bouzidi, Jean-Pierre**
**22300 Lannion (FR)**

(74) Mandataire: **Sciaux, Edmond et al**
**COMPAGNIE FINANCIERE ALCATEL**
**Département Propriété Industrielle**
**54, rue La Boétie**
**75008 Paris (FR)**

(56) Documents cités:
**EP-A- 0 396 351          US-A- 4 612 417**

**Description**

L'invention concerne un étage différentiel d'entrée d'équipement électronique, comportant des moyens pour réduire les perturbations causées par une tension ou un courant appliqué en mode commun à deux entrées de cet étage. Elle concerne en particulier les cartes d'abonné utilisées dans les centraux téléphoniques, et les terminaux d'abonné. Une carte d'abonné est reliée au terminal d'un abonné par une ligne comportant au moins deux conducteurs utilisés pour transmettre des signaux de voix ou de données dans les deux directions, et une tension continue pour télé-alimenter le terminal. Ces signaux sont transmis en mode différentiel, c'est à dire sous la forme d'une différence de tension entre les deux conducteurs.

Les circuits électroniques d'une carte d'abonné ou d'un terminal d'abonné sont soumis à des perturbations, causées par des signaux parasites appliqués en mode commun. Ces perturbations, dites de mode commun, apparaissent sous forme de tensions et de courant d'égales valeurs sur les deux conducteurs de la ligne d'abonné. Les origines de ces tensions et courants sont multiples. Citons la proximité des lignes du réseau d'alimentation à moyenne ou haute tension, et les commutations sur les caténaires d'alimentation de train électrique, au moment du passage d'un train. Plus généralement tout équipement électrique qui induit un courant électrique dans les lignes d'abonné crée des tensions et des courants de mode commun dans cette ligne.

Si une carte d'abonné ou un terminal est sensible aux tensions et courants de mode commun, des perturbations s'ajoutent au signal différentiel utile et peuvent ainsi altérer la transmission du signal utile. Dans le cas de liaisons téléphoniques numériques, le problème est particulièrement grave car une communication peut être gravement altérée voire même interrompue par ces perturbations. Pour se prémunir contre de telles perturbations, des moyens de protection sont mis en oeuvre du coté du central, dans les cartes d'abonné, et du côté des abonnés, dans les terminaux.

Pour réduire ces perturbations, dans une carte d'abonné, on utilise classiquement un transformateur et une inductance. L'inductance atténue considérablement la transmission des perturbations dues aux tensions et courants de mode commun, vers le générateur de télé-alimentation. Le transformateur arrête la composante continue du courant de télé-alimentation, et atténue considérablement la transmission des perturbations dues aux tensions et courants de mode commun, vers les circuits électroniques qui traitent les signaux de voix et de données. Grâce au transformateur, l'atténuation des perturbations de mode commun atteint aisément 60 dB. Un tel dispositif présente des inconvénients liés à l'utilisation de circuits magnétiques : encombrement et poids, ne permettant aucune perspective d'intégration des composants.

Le document **US 4.612.417** décrit un étage différentiel de sortie pour une carte d'abonné, cette carte étant susceptible d'être utilisée dans un central téléphonique pour être reliée à une ligne d'abonné. Cet étage différentiel de sortie comporte des moyens pour réduire les perturbations causées par une tension ou un courant appliqué en mode commun sur la ligne d'abonné. Il comporte deux voies reliant chacune une entrée de cet étage à une sortie de cet étage. Pour réduire les perturbations, il comporte sur chaque voie des moyens pour ajouter à la tension d'entrée de la voie considérée une tension de contre-réaction, et des moyens pour fournir cette tension de contre-réaction qui est égale à la demi somme des tensions respectivement présentes sur les sorties, avec un signe opposé. Les perturbations sont complètement neutralisées si la tension de contre-réaction a exactement une valeur égale à l'opposée de la demi-somme des tensions respectivement présentes sur les sorties. En pratique, l'inverseur utilisé pour inverser le signe de cette tension provoque un certain retard de phase qui nuit à l'efficacité de la contre-réaction.

Le but de l'invention est de proposer un étage différentiel d'entrée permettant de réduire les perturbations de mode commun, sans utiliser de transformateur, ni d'inductance, mais procurant une grande efficacité.

L'objet de l'invention est un étage différentiel d'entrée d'équipement électronique, comportant des moyens pour réduire les perturbations causées par une tension ou un courant appliqué en mode commun à deux entrées de cet étage ; cet étage comportant deux voies reliant chacune une entrée à une sortie ; et chaque voie comportant des premiers moyens pour réduire les perturbations, comportant, des moyens pour ajouter à la tension d'entrée de la voie considérée une première tension de contre-réaction, et des moyens pour fournir une première tension de contre-réaction qui est égale à la demi somme des tensions respectivement présentes sur les entrées, avec un signe opposé ;

caractérisé en ce que, pour réduire l'effet d'un retard introduit par les composants des moyens pour fournir la première tension de contre-réaction, cet étage comporte en outre des moyens pour ajouter en outre à la tension d'entrée de chaque voie une seconde tension de contre-réaction, et des moyens pour fournir une seconde tension de contre-réaction qui est fonction de la tension sur l'entrée correspondant à cette voie, avec un signe opposé, et avec un retard identique à celui provoqué par les composants des moyens pour fournir la première tension de contre-réaction.

L'étage ainsi caractérisé permet de réduire très efficacement les perturbations de mode commun sur chaque voie parce que la seconde tension de contre-réaction permet de compenser l'effet du retard provoqué par les composants des moyens pour fournir une première tension de contre-réaction.

Selon un autre mode de réalisation, l'étage différentiel selon l'invention comporte en outre, en amont des premiers moyens pour réduire les perturbations, des seconds moyens pour réduire les perturbations de mode commun, comportant, sur chacune des voies, des moyens pour ajouter à la tension d'entrée de la voie considérée une troisième tension de contre-réaction et des moyens pour fournir une troisième tension de contre-réaction qui est égale à k fois la demi somme des tensions respectivement présentes sur les entrées de l'étage différentiel, avec un signe opposé ; k étant un coefficient positif et inférieur ou égal à 1.

Ce mode de réalisation permet de réduire la consommation d'énergie électrique par rapport au précédent mode de réalisation, parce que :

- les seconds moyens pour réduire les perturbations opèrent une réduction de la tension de mode commun appliquée aux premiers moyens de réduction (situés en aval), ce qui permet d'alimenter ces premiers moyens avec une tension d'alimentation beaucoup plus faible que dans le deuxième mode de réalisation ;
- et d'autre part, ces seconds moyens pour réduire les perturbations n'entraînent pas eux-mêmes une augmentation sensible de consommation parce que les moyens pour ajouter la troisième tension de contre-réaction comportent :

  -- deux additionneurs qui peuvent être constitués de composants passifs seulement,
  -- et un inverseur unique, consommant moins que les moyens pour fournir la seconde tension de contre-réaction dans le second mode de réalisation (comportant typiquement trois inverseurs), pour une même valeur de tension d'alimentation.

D'autre part, si on prend k sensiblement inférieur 1, on peut réduire aussi la consommation de cet inverseur unique.

L'invention sera mieux comprise et d'autres caractéristiques apparaîtront à l'aide de la description ci-dessous et des figures l'accompagnant :

- La figure 1 représente le schéma synoptique d'un exemple de réalisation d'étage différentiel d'entrée comportant des moyens analogues à ceux décrits dans le document US 4.1612.417 pour réduire les perturbations causées par une tension ou un courant appliqué en mode commun sur la ligne d'abonné.
- La figure 2 représente le schéma synoptique d'un premier exemple de réalisation de l'étage différentiel selon l'invention, présentant une meilleure réduction des perturbations de mode commun.
- La figure 3 représente le schéma synoptique d'un second exemple de réalisation de l'étage différentiel selon l'invention, présentant une consommation électrique nettement plus faible que celle du mode de réalisation représenté sur la figure 2.

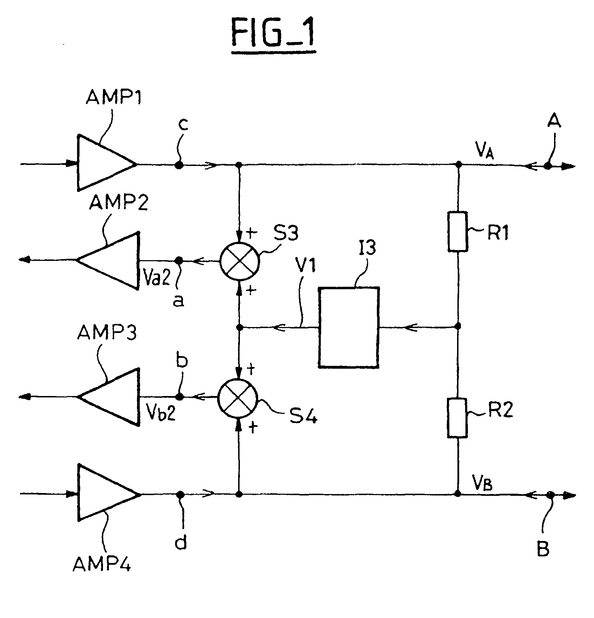

L'exemple de réalisation, représenté sur la **figure 1,** est destiné à être utilisé comme étage d'entrée-sortie dans une carte d'abonné. Il comporte :

- deux bornes A et B destinées à être reliée à une ligne d'abonné ;
- deux bornes de sortie, a et b, reliées respectivement aux entrées de deux amplificateurs AMP2 et AMP3 de la carte d'abonné ;
- deux bornes d'entrées c et d reliées respectivement aux sorties de deux amplificateurs AMP1 et AMP4 de la carte d'abonné, et reliées respectivement aux bornes d'entrée-sortie A et B ;
- un pont constitué de deux résistances R1 et R2, de valeurs égales, placées entre les bornes A et B ;
- un inverseur I3 ayant une entrée reliée au point milieu du pont R1R2 ;
- un additionneur S3 ayant : une entrée reliée aux bornes c et A , une entrée reliée à la sortie de l'inverseur I3, et une sortie reliée à la borne de sortie a ;
- un additionneur S4 ayant : une entrée reliée aux bornes d et B , une entrée reliée à la sortie de l'inverseur I3, et une sortie reliée à la borne de sortie b.

Deux tensions VA et VB sont présentes respectivement sur les bornes d'entrée-sortie A et B :

$$VA = VdA + Vmc$$

$$VB = VdB + Vmc$$

avec

$$VdA = -VdB$$

où VdA est la tension du signal différentiel sur la borne A,

VdB est la tension du signal différentiel sur la borne B,

et Vmc est la tension de mode commun sur les bornes A et B.

Le point milieu du pont R1R2 fournit une tension (VA+VB)/2 égale à la tension Vmc appliquée en mode commun sur la ligne d'abonné. Si l'inverseur I3 est un inverseur parfait, sans retard entre le signal d'entrée et le signal de sortie, sa fonction de transfert est simplement -1. La sortie de l'inverseur I3 fournit une tension de contre-réaction V1 =-(VA+VB)/2=-Vmc

L'additionneur S3 additionne V1 à la tension d'entrée VA pour annuler la tension de mode commun Vmc. Il fournit donc à la borne de sortie a une tension :

$$VA = VdA$$

De même, la sortie de l'additionneur S3 fournit alors à la borne de sortie b une tension :

$$Vb = VdB$$

La tension VA du signal différentiel fourni à l'amplificateur AMP2 est indépendante de la tension de mode commun Vmc, dans la mesure où les composants R1, R2, I3 sont parfaits. La perturbation constituée par cette tension de mode commun est donc éliminée. Il en est de même pour la tension Vb fournie à l'amplificateur AMP3. Cet étage différentiel réalise donc une annulation des perturbations causées par la tension en mode commun Vmc.

Dans la réalité, un inverseur n'est jamais parfait et entraîne un retard de phase sur le signal inversé. Ce retard diminue l'efficacité de l'annulation des perturbations causées par la tension en mode commun. En effet, considérons un retard non nul : La fonction de transfert de l'inverseur I3 dans le domaine des fréquences devient :

$-e^{-i\varphi}$ où $^{-i\varphi}$ représente le retard de phase introduit par l'inverseur.

Dans le domaine des fréquences, les équations représentant les tensions aux bornes A, B, a, b deviennent :

$$VA = VdA + Vmc$$

$$VB = VdB + Vmc$$

$$V1 = Vmc.(1 - e^{i\varphi})$$

$$Va = VdA + V1 = VdA + Vmc.(1 - e^{-i\varphi})$$

$$Vb = VdB + V1 = VdB + Vmc.(1 - e^{-i\varphi})$$

Ces équations montrent que les tensions VA et VB dépendent de la tension en mode commun Vmc. L'annulation des perturbations n'est donc pas complète.

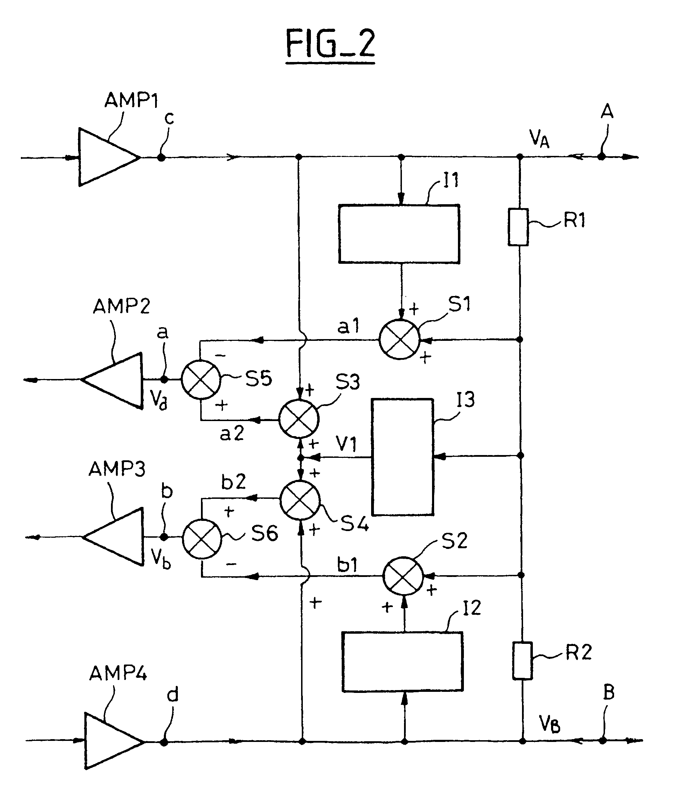

La **figure 2** représente le schéma synoptique d'un premier exemple de réalisation procurant une meilleure réduction des perturbations de mode commun, lorsque l'inverseur I3 n'est pas parfait. Ce second exemple comporte notamment des moyens identiques aux moyens constituant l'exemple de réalisation précédent, sauf que les sorties des additionneurs S3 et S4 ne sont plus reliées directement aux bornes a et b respectivement. Il comporte donc :

- deux bornes A et B destinées à être reliées à une ligne d'abonné ;
- deux bornes de sortie a et b reliées respectivement aux entrées de deux amplificateurs AMP2 et AMP3 des circuits d'abonné ;
- deux bornes d'entrées c et d reliées respectivement aux sorties de deux amplificateurs AMP1 et AMP4, et reliées respectivement aux bornes d'entrée-sortie A et B ;
- un pont de deux résistances R1 et R2, de valeurs égales, placé entre les bornes A et B ;
- un inverseur I3 ayant une entrée reliée au point milieu du pont R1R2 ;
- un additionneur S3 ayant une entrée reliée aux bornes c et A , une entrée reliée à la sortie de l'inverseur I3, et une sortie a2 ;

- un additionneur S4 ayant une entrée reliée aux bornes d et B , une entrée reliée à la sortie de l'inverseur I3, et une sortie b2.

Il comporte les moyens supplémentaires suivant :

- un inverseur I1 ayant une entrée reliée aux bornes A et c, et une sortie ;
- un inverseur I2 ayant une entrée reliée aux bornes B et d, et une sortie ;
- un additionneur S1 ayant deux entrées reliées respectivement au point milieu du pont R1R2 et à la sortie de l'inverseur I1, et ayant une sortie a1 ;
- un additionneur S2 ayant deux entrées reliées respectivement au point milieu du pont R1R2 et à la sortie de l'inverseur I2, et ayant une sortie a2;
- un additionneur S5 ayant : une entrée inversante reliée à la sortie a1 de l'additionneur S1, une entrée non inversante reliée à la sortie a2 de l'additionneur S3, et une sortie reliée à la borne de sortie a ;
- un additionneur S6 ayant : une entrée inversante reliée à la sortie b1 de l'additionneur S2, une entrée non inversante reliée à la sortie b2 de l'additionneur S4, et une sortie reliée à la borne de sortie b.

Les inverseurs I1, I2, I3 ont respectivement des fonctions de transfert :

$$-e^{-i\varphi 1} \, , \, -e^{-i\varphi 2} \, , \, - e^{-i\varphi 3}$$

L'amélioration du dispositif consiste à ajouter en outre à la tension d'entrée de chaque voie une seconde tension de contre-réaction, qui neutralise la perturbation résiduelle dont la tension est égale à $Vmc.(1 - e^{-i\varphi})$. Cette seconde tension de contre-réaction est obtenue notamment à partir de la tension d'entrée correspondant à cette voie, en inversant cette tension par un second inverseur provoquant un retard identique à celui provoqué par le premier inverseur I3.

Les tensions sur les bornes d'entrée-sortie A et B sont :

$$VA = VdA + Vmc$$

$$VB = VdB + Vmc$$

$$V1 = -Vmc. \, e^{-i\varphi 3}$$

La tension à la sortie a1 de l'additionneur S1 est :

$$Va1 = -e^{-i\varphi 1}.(VdA+Vmc) + (VA+VB)/2 = -VdA . \, e^{-i\varphi 1} + Vmc.(1 - e^{-i\varphi 1})$$

La tension à la sortie b1 de l'additionneur S2 est :

$$Vb1 = -e^{-i\varphi 2}.(VdB+Vmc) + (VA+VB)/2 = -VdB . \, e^{-i\varphi 2} + Vmc.(1 - e^{-i\varphi 2})$$

La tension à la sortie a2 de l'additionneur S3 est :

$$Va2 = VdA + Vmc - Vmc. \, e^{-i\varphi 3} = VdA + Vmc.(1 - e^{-i\varphi 3})$$

La tension à la sortie b2 de l'additionneur S4 est :

$$Vb2 = VdB + Vmc - Vmc. \, e^{-i\varphi 3} = VdB + Vmc.(1 - e^{-i\varphi 3})$$

La tension à la sortie a de l'additionneur S5 est :

$$Va = Va2 - Va1 = VdA.(1 + e^{-i\varphi 1}) + Vmc.(e^{-i\varphi 1} - e^{-i\varphi 3})$$

La tension à la sortie b de l'additionneur S6 est :

$$Vb = Vb2 - Vb1 = VdB.(1 + e^{-i\varphi 2}) + Vmc.(e^{-i\varphi 2} - e^{-i\varphi 3})$$

Comme les inverseurs I1, I2, I3 sont réalisés suivant le même schéma électrique, il est possible de considérer en première approximation que leurs fonctions de transfert sont toutes égales à - $e^{-i\varphi}$ . Alors :

$$Va \approx VdA.(1 + e^{-i\varphi}) \approx 2\ VdA$$

$$Vb \approx VdB.(1 + e^{-i\varphi}) \approx 2\ VdB$$

On constate que la tension Va et la tension Vb sont indépendantes de la valeur de la tension de mode commun Vmc, bien que le retard des inverseurs ne soit pas nul. Il y a donc élimination des perturbations causées par la tension de mode commun Vmc. Il en est de même pour un courant de mode commun. Avec ce second exemple de réalisation, on a obtenu des affaiblissements de 50 dB pour des tensions et courants de mode commun.

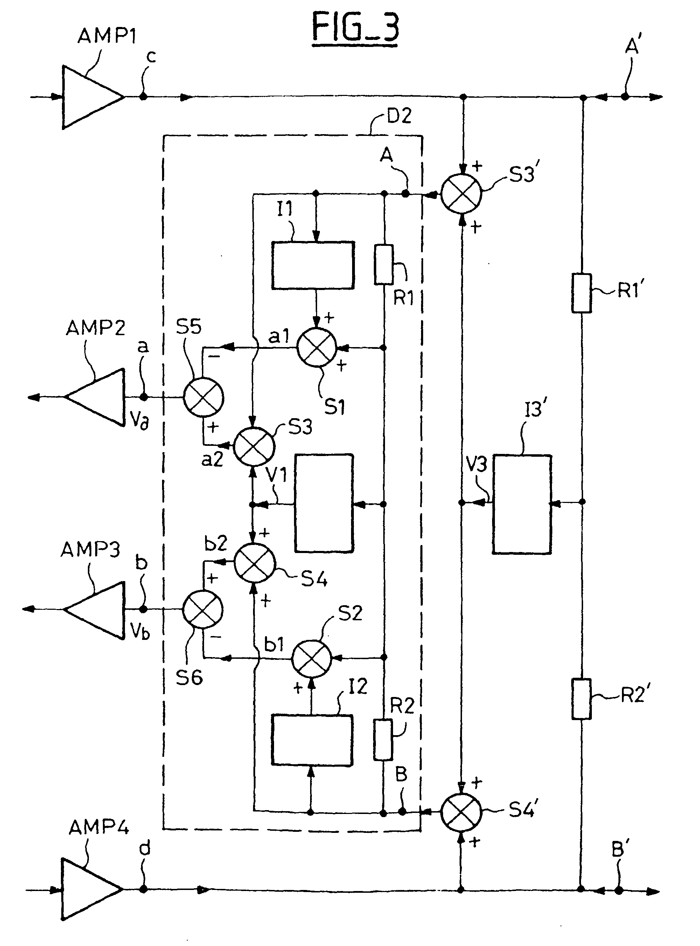

La **figure 3** représente le schéma synoptique d'un second exemple de réalisation de l'étage différentiel selon l'invention, présentant une meilleure réduction des perturbations que l'exemple de réalisation représenté sur la figure 1, et une consommation électrique nettement plus faible que celle de l'exemple de réalisation représenté sur la figure 2. Il comporte notamment un circuit D2 identique à l'exemple de réalisation représenté sur la figure 2, sauf que les bornes A et B ne sont plus les bornes d'entrée-sortie de l'étage différentiel. Les bornes d'entrée-sortie sont des bornes A' et B' reliée respectivement aux bornes d'entrée c et d de l'étage différentiel, et à un dispositif supplémentaire de réduction des perturbations. Ce dispositif supplémentaire est placé en amont du circuit D2, et il a une structure analogue à celle de l'étage différentiel représenté sur la figure 1, pour réaliser une première réduction de la tension de mode commun. Ce dispositif supplémentaire comporte :

- deux bornes A' et B' destinées à être reliées à une ligne d'abonné ;
- deux bornes de sortie reliées respectivement aux entrées A et B du circuit D 2 ;
- deux bornes d'entrée c et d reliées respectivement aux sorties de deux amplificateurs AMP1 et AMP4 de la carte d'abonné, et reliées respectivement aux bornes d'entrée-sortie A' et B' ;
- un pont constitué de deux résistances R1' et R2', de valeurs égales, placées entre les bornes A' et B' ;
- un inverseur I3' ayant une entrée reliée au point milieu du pont R1'R2' ;
- un additionneur S3' ayant : une entrée reliée aux bornes c et A' , une entrée reliée à la sortie de l'inverseur I3', et une sortie reliée à la borne A ;
- un additionneur S4' ayant : une entrée reliée aux bornes d et B' , une entrée reliée à la sortie de l'inverseur I3', et une sortie reliée à la borne B.

Deux tensions VA' et VB' sont présentes respectivement sur les bornes d'entrée-sortie A' et B' :

$$VA' = VdA' + Vmc$$

$$VB' = VdB' + Vmc$$

avec

$$VdA' = -VdB'$$

où VdA' est la tension du signal différentiel sur la borne A',
VdB' est la tension du signal différentiel sur la borne B',
et Vmc est la tension de mode commun sur les bornes A' et B'.

Le point milieu du pont R1'R2' fournit une tension (VA'+VB')/2 égale à la tension Vmc appliquée en mode commun sur la ligne d'abonné. Si l'inverseur I3' est un inverseur parfait, sans retard entre le signal d'entrée et le signal de sortie, sa fonction de transfert est simplement -1. La sortie de l'inverseur I3' fournit une tension de contre-réaction V3=-(VA'+VB')/2=-Vmc

L'additionneur S3' additionne V3 à la tension d'entrée VA' pour annuler la tension de mode commun Vmc. Il fournit donc à la borne A une tension :

$$VA = VdA'$$

De même, la sortie de l'additionneur S4' fournit alors à la borne B une tension :

$$VB = VdB'$$

La tension VA du signal différentiel fourni au circuit D2 est indépendante de la tension de mode commun Vmc, dans la mesure où les composants R1', R2', I3' sont parfaits. La perturbation constituée par cette tension de mode commun est donc éliminée (ou au moins réduite). Il en est de même pour la tension VB. Ce dispositif supplémentaire réalise donc une première réduction des perturbations causées par la tension en mode commun Vmc ; mais en outre il permet de concevoir le circuit D2 de manière à ce qu'il consomme moins d'énergie électrique.

En effet, puisque la tension de mode commun est annulée (ou au moins fortement réduite) sur les bornes A et B, les tensions appliquées aux entrées des inverseurs I1, I2, I3 sont réduites. Il est alors possible de les alimenter avec une tension plus faible, sans risquer une saturation. Cependant, l'inverseur I3' doit pouvoir travailler avec un tension de mode commun élevée. Il lui faut donc une tension d'alimentation élevée. Globalement il y a une économie d'énergie puisque l'inverseur I3' est le seul à devoir être alimenté avec une tension élevée, alors que dans le mode de réalisation représenté sur la figure 2, trois inverseurs I1, I2, I3 doivent être alimentés avec une tension élevée.

Ce second mode de réalisation peut être modifié pour réduire la consommation de l'inverseur I3'. Cette modification consiste à utiliser un inverseur I3' ayant un gain k supérieur à zéro et inférieur à 1. Alors :

$$VA = VdA + Vmc \cdot (1 - k)$$

$$VB = VdB + Vmc \cdot (1 - k)$$

La neutralisation de la tension de mode commun Vmc par cet inverseur I3' n'est donc pas complète, mais elle sera complétée dans l'étage suivant comprenant les inverseurs I1, I2, I3. Par contre, l'inverseur I3' nécessite alors une tension d'alimentation plus faible, ce qui réduit la consommation d'énergie électrique de l'inverseur I3'. La valeur de k est choisie en tenant compte des conditions d'amplitude des tensions et courants de mode commun, et de la consommation globale souhaitée.

**Revendications**

**1.** Etage différentiel (1) d'entrée d'équipement électronique, comportant des moyens pour réduire les perturbations causées par une tension ou un courant appliqué en mode commun à deux entrées (A ; B) de cet étage ; cet étage comportant deux voies reliant chacune une entrée (A ; B) à une sortie (a ; b) ; chaque voie comportant des premiers moyens pour réduire les perturbations, ces premiers moyens comportant, sur chacune des voies, des moyens (S3 ; S4) pour ajouter à la tension d'entrée de la voie considérée une première tension de contre-réaction (V1), et des moyens (R1, R2, I3) pour fournir une première tension de contre-réaction qui est égale à la demi somme des tensions (VA ; VB) respectivement présentes sur les entrées (A ; B), avec un signe opposé ;

    **caractérisé en ce que**, pour réduire l'effet d'un retard introduit par les composants des moyens (R1, R2, I3) pour fournir la première tension de contre-réaction (V1), cet étage comporte en outre des moyens (S5 ; S6) pour ajouter en outre à la tension d'entrée de chaque voie une seconde tension de contre-réaction (a1 ; b1), et des moyens (R1, R2, ; I1, S1 ; I2, S2) pour fournir une seconde tension de contre-réaction (a1 ; b1) qui est fonction de la tension (VA ; VB) sur l'entrée correspondant à cette voie, avec un signe opposé, et avec un retard identique à celui provoqué par les composants des moyens (R1, R2, I3) pour fournir la première tension de contre-réaction (V1).

**2.** Etage selon la revendication 1, **caractérisé en ce qu'**il comporte en outre, en amont des premiers moyens pour réduire les perturbations, des seconds moyens pour réduire les perturbations de mode commun, comportant, sur chacune des voies, des moyens (S3' ; S4') pour ajouter à la tension d'entrée de la voie considérée une troisième tension de contre-réaction (V3), et des moyens (R1', R2', I3') pour fournir une troisième tension de contre-réaction qui est égale à k fois la demi somme des tensions respectivement présentes sur les entrées (A' ; B') de l'étage différentiel, avec un signe opposé ; k étant un coefficient positif et inférieur ou égal à 1.

**3.** Etage selon la revendication 2, **caractérisé en ce que** les moyens (R1', R2', I3') pour fournir une troisième tension de contre-réaction (V3) comportent un pont de deux résistances (R1', R2'), branché sur les entrées (A', B') de l'étage différentiel, et un inverseur (I3') ayant une entrée reliée au point milieu du pont et ayant une sortie fournissant la troisième tension de contre-réaction (V3).

**Patentansprüche**

**1.** Differenzeingangsstufe (1) eines elektronischen Geräts mit Mitteln zur Reduzierung von Strom- und Spannungsstörungen durch auf zwei Eingänge (A; B) dieser Stufe angewendete Gleichtaktsignale; hierbei umfasst diese Stufe zwei Kanäle, die jeweils einen Eingang (A; B) mit einem Ausgang (a; b) verbinden, wobei jeder Kanal erste Mittel zur Reduzierung der Störungen aufweist, wobei diese ersten Mittel auf jedem der Kanäle Mittel (S3; S4) umfassen, um zur Eingangsspannung des betrachteten Kanals eine erste gegengekoppelte Spannung (V1) hinzuzufügen, und Mittel (R1, R2, I3), um eine erste gegengekoppelte Spannung zu liefern, die gleich der halben Summe der an den Eingängen (A; B) anliegenden Spannungen (VA; VB) ist, und zwar mit entgegengesetztem Vorzeichen;

dadurch gekennzeichnet, dass zur Reduzierung der Auswirkungen einer Verzögerung, die von den Komponenten der Mittel (R1, R2, I3) zur Lieferung der ersten gegengekoppelten Spannung (V1) eingeführt wird, diese Stufe außerdem Mittel (S5; S6) umfasst, um außerdem zur Eingangsspannung jedes Kanals eine zweite gegengekoppelte Spannung (a1; b1) hinzuzufügen, sowie Mittel (R1, R2; I1, S1; I2, S2), um eine zweite gegengekoppelte Spannung (a1; b1) zu liefern, die abhängig ist von der Spannung (VA, VB) am entsprechenden Eingang dieses Kanals, und zwar mit einem entgegengesetzten Vorzeichen und mit einer identischen Verzögerung wie jener, die durch die Komponenten der Mittel (R1, R2, I3) verursacht wird, um die erste gegengekoppelte Spannung (V1) zu liefern.

**2.** Stufe nach Anspruch 1, **dadurch gekennzeichnet, dass** sie außerdem vor den ersten Mitteln zur Reduzierung der Störungen zweite Mittel zur Reduzierung der Gleichtaktstörungen umfasst, welche auf jedem der Kanäle Mittel (S3'; S4') umfassen, um zu der Eingangsspannung des betrachteten Kanals eine dritte gegengekoppelte Spannung (V3) hinzuzufügen, sowie Mittel (R1', R2', I3'), um eine dritte gegengekoppelte Spannung zu liefern, die gleich dem k-Fachen der halben Summe der Spannungen ist, welche jeweils an den Eingängen (A'; B') der Differenzstufe anliegen, und zwar mit einem entgegengesetzten Vorzeichen, wobei k ein positiver Koeffizient kleiner oder gleich 1 ist.

**3.** Stufe nach Anspruch 2, **dadurch gekennzeichnet, dass** die Mittel (R1', R2', I3') zum Liefern einer dritten gegengekoppelten Spannung (V3) eine Brücke aus zwei Widerständen (R1', R2') umfassen, die mit den Eingängen (A'; B') der Differenzstufe verbunden ist, und einen Inverter (I3'), von dem ein Eingang mit dem Mittelpunkt der Brücke verbunden ist und von dem ein Ausgang die dritte gegengekoppelte Spannung (V3) liefert.

**Claims**

**1.** Differential input stage (1) of electronic equipment, comprising means for reducing the interference caused by a voltage or current applied in common mode to two inputs (A; B) of this stage; this stage comprising two channels each connecting one input (A; B) to one output (a; b); each channel comprising first means for reducing interference, these first means comprising, on each of the channels, means (S3; S4) for adding to the input voltage of the channel concerned a first feedback voltage (V1), and means (R1, R2, I3) for supplying a first feedback voltage that is equal to half the sum of the voltages (VA; VB) present at the inputs (A; B), respectively, with the opposite sign; **characterized in that**, to reduce the effect of a delay introduced by the components of the means (R1, R2, I3) for supplying the first feedback voltage (V1), this stage further comprises means (S5; S6) for further adding to the input voltage of each channel a second feedback voltage (a1; b1) and means (R1, R2; I1, S1; I2, S2) for supplying a second feedback voltage (a1; b1) that is a function of the voltage (VA; VB) at the input corresponding to this channel, with the opposite sign, and with a delay identical to that caused by the components of the means (R1, R2, I3) for supplying the first feedback voltage (V1).

2. Stage according to claim 1, **characterized in that** it further comprises, on the upstream side of the first means for reducing interference, second means for reducing common mode interference, comprising, on each of the channels, means (S3'; S4') for adding to the input voltage of the channel concerned a third feedback voltage (V3), and means (R1', R2', I3') for supplying a third feedback voltage that is equal to k times half the sum of the voltages present at the inputs (A'; B'), respectively, of the differential stage, with the opposite sign; k being a positive coefficient less than or equal to 1.

3. Stage according to claim 2, **characterized in that** the means (R1', R2', I3') for supplying a third feedback voltage (V3) comprise a bridge of two resistors (R1', R2'), connected to the inputs (A', B') of the differential stage, and an inverter (I3') having an input connected to the mid-point of the bridge and having an output supplying the third feedback voltage (V3).

# FIG_1

# FIG_2

## FIG_3